# EUROPEAN PATENT APPLICATION

(11) **EP 2 749 620 A1**
(43) Date of publication of application: **02.07.2014**
(21) Application number: 12825386.1
(22) Date of filing: 10.08.2012
(51) Int. Cl.: C09J 133/00, C09J 4/02, C09J 9/02, C09J 11/04, C09J 133/14, H01L 31/042

(54) **CONDUCTIVE ADHESIVE AND SOLAR CELL MODULE**

(30) Priority: 23.08.2011 JP 2011181953
(71) Applicant: Dexerials Corporation, Tokyo 141-0032 (JP)
(72) Inventor: SUZUKI, Kazutoshi, Tokyo 141-0032 (JP)
(74) Representative: Müller - Hoffmann & Partner
(86) International application number: PCT/JP2012/070463
(87) International publication number: WO 2013/027606

(57) **Abstract**

Provided are a conductive adhesive having a high heat resistance, and a solar cell module. A bus bar electrode (11) on a surface of a solar cell and an Al back-surface electrode (13) of another adjacent solar cell are electrically connected to a tab wire with a conductive adhesive interposed therebetween, and as the conductive adhesive, a material, which contains an acrylic resin, a radical polymerization initiator and conductive particles, and has a glass transition temperature of 150°C or more to 180°C or less, after being cured, and a tan δ peak value of 0.25 or more to 0.60 or less, is used.

## Description

### Field of the Invention

This invention relates to a conductive adhesive in which conductive particles are dispersed, and a solar cell module in which the conductive adhesive is used for connection between an electrode and a tab wire of the solar cell. The present application asserts priority rights based on JP Patent Application 2011-181953 filed in Japan on August 23, 2011. The total contents of disclosure of the Patent Application of the senior filing date are to be incorporated by reference into the present Application.

### Background of the Invention

In recent years, in solar cell modules, upon connecting an electrode and a tab wire of a solar cell, a conductive adhesive film capable of carrying out the connection by a thermal press-bonding process at a comparatively low temperature is used (for example, see Patent Document 1). The tab wire has its one end connected to a surface electrode of one solar cell, with the other end being connected to a back surface electrode of another solar cell, so that respective solar cells are connected in series with one another.

### Prior-Art Documents

### Patent Documents

PTL 1: Japanese Patent Application Laid-Open No. 2009-283606
PTL 2: Japanese Patent Application Laid-Open No. 2007-214533

### Summary of the Invention

In the case when a solar cell module is operated under a high outside temperature in summer or the like, the module temperature is considered to be raised up to about 70 to 80°C. Moreover, when a hot spot phenomenon occurs, an abnormal heat generation 10 to 20°C or more higher than the peripheral temperature tends to sometimes occur.

Under an environment in which such an abnormal heat generation might occur, even in the case of a solar cell module in which a conductive adhesive film that has cleared a temperature cycle test (- 40°C ↔ 90°C) in JIS C8917 or an environmental test condition (- 40°C ↔ 100°C) is used, a guaranteed period of 20 to 30 years that is currently demanded might not be achieved.

In view of these circumstances, the present invention has been devised, and its object is to provide a conductive adhesive having high heat resistance and a solar cell module.

In order to solve the above-mentioned problems, a conductive adhesive in accordance with the present invention contains an acrylic resin, a radical polymerization initiator and conductive particles, and is characterized by having a glass transition temperature after a curing process in a range from 150°C or more to 180°C or less, with a tan δ peak value being set to 0.25 or more to 0.60 or less.

Moreover, a solar cell module in accordance with the present invention is provided with one solar cell and the other solar cell adjacent to the one solar cell, each solar cell having a surface electrode and a back-surface electrode, with the surface electrode of the one solar cell and the back-surface electrode of the other solar cell being electrically connected to a tab wire, with a conductive adhesive being interposed therebween, and the conductive adhesive, which contains an acrylic resin, a radical polymerization initiator and conductive particles, is characterized by having a glass transition temperature after a curing process in a range from 150°C or more to 180°C or less, with a tan δ peak value being set to 0.25 or more to 0.60 or less.

### Effects of Invention

In the present invention, by using an acrylic resin having high heat resistance, as well as by setting a glass transition temperature after a curing process to 150°C or more to 180°C or less with a tan δ peak value being set to 0.25 or more to 0.60 or less, it becomes possible to provide superior heat resistance.

### Brief Description of Drawings

Figure 1 is a drawing that schematically shows a product mode of a conductive adhesive film.
Figure 2 is a drawing that shows a structural example of a solar cell module.
Figure 3 is a schematic cross-sectional view of a solar cell.
Figure 4 is a drawing that shows a structure of a reduced-pressure laminator.

### Detailed Description of the Invention

Referring to Figs, the following description will discuss embodiments of the present invention in detail in the following order.
1. Conductive adhesive
2. Production Method for Conductive adhesive
3. Solar Cell Module
4. Production Method for Solar Cell Module
5. Examples

### <1. Conductive adhesive>

First, the following description will discuss a conductive adhesive for use in electrically connecting a surface electrode or a back-surface electrode and a tab wire of a solar cell. In this case, the shape of the conductive adhesive is not limited to a film shape, but may be prepared as a paste.

The conductive adhesive in the present embodiment contains an acrylic resin, a radical polymerization initiator and conductive particles. Moreover, as other additive compositions, a film-forming resin, a thermoplastic elastomer, a silane coupling agent, an inorganic filler, or the like are preferably contained therein.

The acrylic resin is a polymer of acrylic acid esters (acrylates) or methaclylic esters (methyl methacrylates). As the acrylic resin, examples thereof include: methylacrylate, ethylacrylate, isopropylacrylate, isobutylacrylate, epoxyacrylate, ethylene glycol diacrylate, diethylene glycol diacrylate, trimethylol propane triacrylate, dimethylol tricyclodecane diacrylate, tetramethylene glycol tetraacrylate, 2-hydroxy-1,3-diacryloxy propane, 2,2-bis[4-(acryloxymethoxy)phenyl] propane, 2,2-bis[4-acryloxyethoxy]phenyl] propane, dicyclopentenyl acrylate, tricyclodecanyl acrylate, tris (acryloxyethyl) isocyanurate, urethane acrylate, etc. One of these may be used alone, or two or more kinds of these may be used in combination. Moreover, those composites obtained by forming the acrylates into methacrylates may be used, and one of these may be used alone, or two or more kinds of these may be used in combination.

Moreover, as the acrylic resin, acrylate containing a phosphoric acid ester group is preferably used. As the acrylic acid ester containing phosphorus, examples thereof include: mono (2-acryloyloxyethyl) acid phosphate, mono (2-acryloyloxypropyl) acid phosphate, mono (2-acryloyloxybutyl) acid phosphate, etc. By compounding acrylate containing a phosphoric acid ester group therein, the adhesion on the surface of an inorganic substance such as metal can be improved.

As the radical polymerization initiator, a conventionally known composite may be used, and among these, an organic peroxide is preferably used. As the organic peroxide, examples thereof include: benzoyl peroxide, lauroyl peroxide, butyl peroxide, benzyl peroxide, dilauroyl peroxide, dibutyl peroxide, peroxydicarbonate, etc.

As the conductive particles, for example, metal particles of nickel, gold, copper or the like, or resin particles to which gold plating or the like is applied may be used. From the viewpoint of connection reliability, the average particle size of the conductive particles is preferably set to 1 to 20 µm, more preferably, to 2 to 10 µm. Moreover, from the viewpoints of connection reliability and insulation reliability, the average particle density of the conductive particles is preferably set to 500 to 50000 particles/mm², more preferably, to 1000 to 30000 particles/mm².

The film-forming resin corresponds to a high molecular-weight resin having an average molecular weight of 10000 or more, and from the viewpoint of a film-forming property, is preferably designed to have an average molecular weight of about 10000 to 80000. As the film-forming resin, various resins, such as an epoxy resin, a modified epoxy resin, a urethane resin, a phenoxy resin, or the like, may be used, and among these, from the viewpoints of film-forming state, connection reliability, etc., a phenoxy resin is preferably used.

The thermoplastic elastomer exerts such behaviors as to be softened when heated to exhibit flowability, and to return to a rubber-state elastic substance when cooled. As the thermoplastic elastomer, rubber-based elastic substances, such as acrylic rubber (ACR), butadiene rubber (BR), nitrile rubber (NBR), or the like may be used. These elastic substances make it possible to absorb an inner stress at the time of connection, and since they cause no curing inhibition, it becomes possible to provide high connection reliability.

As the silane coupling agent, epoxy-based, amino-based, mercapto-sulfide-based, ureide-based agents or the like may be used. By the silane coupling agent, the adhesion property on the interface between an organic material and an inorganic material can be improved.

As the inorganic filler, silica, talc, titanium oxide, calcium carbonate, magnesium oxide, etc., may be used. By the content of the inorganic filler, the flowability can be controlled, thereby making it possible to improve a particle capturing rate.

The conductive adhesive in accordance with the present embodiment exerts superior heat resistance when its glass transition temperature after the curing process is set to 150°C or more to 180°C or less, with a tan δ peak value being set to 0.25 or more to 0.60 or less. In the case when the glass transition temperature after the curing process is less than 150°C, the heat resistance is lowered, and, for example, when it is used for connecting an electrode and a tab wire of a solar cell, the power generating efficiency is lowered in a thermal shock test. Moreover, in the case when the glass transition temperature after the curing process exceeds 180°C, the power generating efficiency is lowered in the thermal shock test. In the case when the tan δ peak value after the curing process is less than 0.25, the adhesion strength deteriorates, and in the case when the tan δ peak value after the curing process exceeds 0.6, the heat resistance is lowered, and the power generating efficiency is lowered in the thermal shock test.

In this case, tan δ (loss tangent) is calculated by an expression indicated by tan δ = E"/E', and corresponds to a value that is 0 or more to less than 1. Here, E" represents a loss elastic modulus, and E' represents a storage elastic modulus. The tan δ is calculated from the above-mentioned expression by measuring a visco-elastic spectrum of the storage elastic modulus (E') and a visco-elastic spectrum of the loss elastic modulus (E") within a predetermined temperature range at a predetermined frequency by a visco-elasticity tester. Moreover, the glass transition temperature (Tg) is indicated by the temperature of the tan δ peak value.

Moreover, the Asker C2 hardness before the curing process of the conductive adhesive is preferably set to 45 or more to 80 or less. In the case of setting the Asker C2 hardness to 45 or more, it is possible to prevent "oozing" that is a phenomenon in which upon forming the conductive adhesive into a film shape, the adhesive agent composite flows to ooze from the peripheral edge of the film. In the case of setting the Asker C2 hardness to 80 or less, it is possible to sufficiently push the conductive particles at the time of a thermal press-bonding process, and consequently to secure conduction at a low electrical resistance. Additionally, the Asker C2 hardness can be measured by using a durometer (spring-type hardness meter) specified by SRIS0101 (The Society of Rubber Industry, Japan Standard).

In accordance with this conductive adhesive, the tab wire and the electrode can be firmly connected to each other by using a thermal press-bonding process at a comparatively low temperature, making it possible to obtain high connection reliability.

### <2. Production Method for Conductive adhesive>

The following description will discuss the production method for the above-mentioned conductive adhesive. In this case, the explanation will be given to the production method for a conductive adhesive film in which the conductive adhesive is formed into a film shape. The production method for the conductive adhesive film of the present embodiment is provided with a coating step in which a composition containing the aforementioned acrylic resin, radical polymerization initiator, conductive particles, film-forming resin, thermoplastic elastomer, silane coupling agent and inorganic filler is applied onto a peeling substrate, and a drying step for drying the composition on the peeling substrate.

In the coating step, after the composition containing the aforementioned acrylic resin, radical polymerization initiator, conductive particles, film-forming resin, thermoplastic elastomer, silane coupling agent and inorganic filler has been adjusted to have predetermined values in the aforementioned glass transition temperature and the tan δ peak value after the curing process by using an organic solvent, the resulting composition is applied onto the peeling substrate by using a bar coater, an applying device, or the like.

As the organic solvent, for example toluene, ethyl acetate or a mixed solvent of these, or other various organic solvents may be used. Moreover, the peeling substrate is composed of a laminate structure in which, for example, a peeling agent, such as silicone, is applied onto PET (Poly Ethylene Terephthalate), OPP (Oriented Polypropylene), PMP (Poly-4-methylpentene-1), PTFE (Polytetrafluoroethylene), or the like so that the composition is prevented from being dried and the film shape of the composition is maintained.

In the next drying step, the composition on the peeling substrate is dried by using a heating oven, a heating dryer, or the like. Thus, a conductive adhesive film in which the aforementioned conductive adhesive has been formed into a film shape can be obtained.

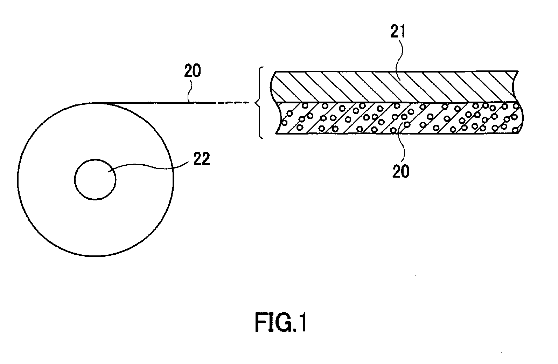

Fig. 1 is a drawing that schematically shows one example of a product mode of the conductive adhesive film. A conductive adhesive film 20 has the aforementioned conductive adhesive layer stacked on a peeling substrate 21, and is molded into a tape shape. This tape-shaped conductive adhesive film is wound around and stacked onto a reel 22 with the peeling substrate 21 being located on the outer circumferential side. Although not particularly limited, the peeling substrate 21 is made of, for example, PET (Poly Ethylene Terephthalate), OPP (Oriented Polypropylene), PMP (Poly-4-methylpentene-1), PTFE (Polytetrafluoroethylene), or the like. Moreover, the conductive adhesive film 20 may have a structure in which a transparent cover film is formed on a conductive adhesive layer, and a tab wire may be used as the cover film to be pasted onto the conductive adhesive layer.
By preliminarily stacking the tab wire and the conductive adhesive film 20 as an integral unit, the peeling substrate 21 is separated therefrom at the time of an actual use, and the conductive adhesive layer of the conductive adhesive film 20 is bonded onto a bus bar electrode and a tab wire connection portion of a back-surface electrode so that the tab wire and the respective electrodes can be connected to one another.

As shown in Fig. 1, in the case when the conductive adhesive film 20 is provided as a reel product around which it is wound, the Asker C2 hardness of the conductive adhesive film 20 is preferably set to 48 or more to 76 or less. In the case when the Asker C2 hardness is 48 or more, it is possible to prevent "oozing" that is a phenomenon in which the adhesive agent composition flows to ooze from the peripheral edge of the film. Moreover, by setting the Asker C2 hardness to 76 or less, it is possible to sufficiently push the conductive particles at the time of the thermal press-bonding process, and consequently to secure conduction at a low electrical resistance. Moreover, in the case when the conductive adhesive film 20 is formed as stripes, with two or more sheets of these being stacked, it is also possible to prevent deformation thereof, and consequently to maintain predetermined dimensions, by setting the hardness within the above-mentioned range in the same manner.

### <3. Solar Cell Module>

Next, the following description will discuss a solar cell module to which the present invention is applied. A solar cell module 1 to which the present invention is applied is a thin-film silicon-based solar cell which uses a crystal silicon-based solar cell module using a single crystal type silicon photoelectric conversion element or a polycrystal-type photoelectric conversion element as a photoelectric conversion element, or a photoelectric conversion element formed by stacking a cell made of amorphous silicon and a cell made of microcrystal silicon and amorphous silicon germanium are stacked.

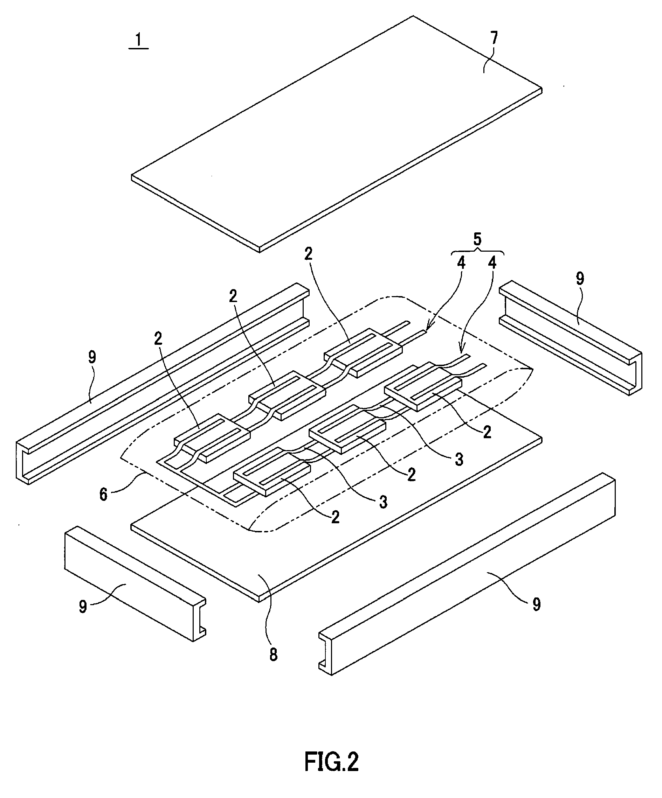

As shown in Fig. 2, the solar cell module 1 is provided with strings 4 each having a structure in which a plurality of solar cells 2 are connected in series with one another by tab wires 3 serving as interconnectors, and a matrix 5 in which a plurality of these strings 4 are arranged. Moreover, the solar cell module 1 is formed by processes in which the matrix 5, sandwiched by sheets 6 of a sealing adhesive agent, is laminated together with a surface cover 7 formed on a light-receiving surface side as a protective substrate and a back sheet 8 formed on a back-surface side in a batch process, and lastly, a metal frame 9 made of aluminum or the like is attached on the peripheral portion thereof.

As the sealing adhesive agent, for example, a translucent sealing material, such as ethylenevinyl alcohol resin (EVA) or the like, is used. Moreover, as the surface cover 7, for example, a translucent material, such as glass, a translucent plastic material, or the like, is used. Furthermore, as the back sheet 8, a laminate or the like in which glass or an aluminum foil is sandwiched by resin films are used.

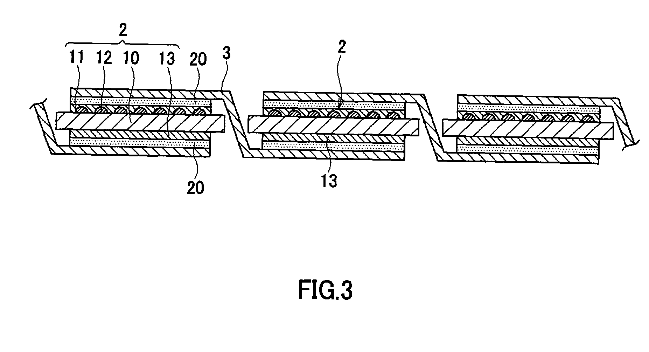

As shown in Fig. 3, each of the solar cells 2 of a solar cell module is provided with a photoelectric conversion element 10 made of a silicon substrate. The photoelectric conversion element 10 has a structure in which a bus bar electrode 11 forming a surface electrode and finger electrodes 12 serving as collector electrodes formed in a direction virtually orthogonal to the bus bar electrode 11 are formed on a light-receiving surface side. Moreover, the photoelectric conversion element 10 is provided with an A1 back-surface electrode 13 made of aluminum and formed on a back-surface side opposite to the light-receiving surface.

Moreover, in the solar cell 2, the bus bar electrode 11 on a surface and the A1 back-surface electrode 13 of an adjacent solar cell 2 are electrically connected to each other by the tab wires 3 and thus, connected in series with one another to form a string 4. The connections among the tab wires 3, the bus bar electrodes 11 and the A1 back-surface electrode 13 are made by using a conductive adhesive film 20.

As the tab wires 3, tab wires used in a conventional solar cell module may be utilized. The tab wires 3 are formed by using, for example, a ribbon-shaped copper foil with a thickness of, for example, 50 to 300 µm, with gold plating, silver plating, tin plating, solder plating, or the like being carried out thereon, if necessary.
Moreover, as the tab wires 3, a laminate member in which the aforementioned conductive adhesive film has been preliminarily stacked may be used.

The bus bar electrode 11 is formed by applying an Ag paste thereto to be heated thereon. The bus bar electrode 11 to be formed on the light-receiving surface of the solar cell 2 is formed into a line shape with a width of, for example, 1 mm so as to reduce an area that blocks incident light rays and consequently to suppress shadow loss. The number of the bus bar electrodes 11 is determined on demand by taking into consideration the size and resistance of the solar cell 2.

The finger electrodes 12 are formed over the virtually entire surface of the light-receiving surface of the solar cell 2 so as to intersect with the bus bar electrode 11 by using the same method as that of the bus bar electrode 11. Moreover, the finger electrodes 12 are arranged such that lines, each having a width of, for example, about 100 µm, are formed with a predetermined interval of, for example, 2 mm.

The A1 back-surface electrode 13 is formed on the back surface of the solar cell 2, with electrodes made of aluminum being formed thereon by using, for example, a screen printing method, a sputtering method, or the like.

Additionally, the solar cell 2 is not necessarily provided with the bus bar electrode 11. In this case, the solar cell 2 is designed such that an electric current from the finger electrodes 12 is collected by the tab wires 3 that intersect with the finger electrodes 12. Moreover, the A1 back-surface electrode 13 may have apertures formed thereon in such a degree as not to cause a connection failure with the tab wires, while maintaining adhesion strength by this structure.

### <4. Production Method for Solar Cell Module>

Referring to Fig. 2, the following description will discuss a method for producing the solar cell module. The production method for the solar cell module in the present embodiment, which is a production method for the solar cell module in which a surface electrode of one solar cell and a back-surface electrode of another solar cell adjacent to the one solar cell are electrically connected to each other by using tab wires with a conductive adhesive material interposed therebetween, is characterized in that the tab wires are disposed on the surface electrode and the back-surface electrode with a conductive adhesive that contains an acrylic resin, a radical polymerization initiator and conductive particles, and has its glass transition temperature after a curing process set to 150°C or more to 180°C or less and its tan δ peak value set to 0.25 or more to 0.60 or less, being interposed therebetween, and thermally pressed thereon.

More specifically, first, an Ag paste is applied onto the surface of the photoelectric conversion element 10, and subjected to a baking process so that the finger electrodes 12 and the bus bar electrode 11 are formed, and on the back surface, an A1 back-surface electrode 13 is formed on each of connection portions of the tab wires 3 by using a screen printing process or the like so that a solar cell is produced.

Next, the conductive adhesive films 20 are pasted onto the bus bar electrodes 11 on the surface of the photoelectric conversion element 10 and the A1 back-surface electrode 13 on the back-surface, and the tab wires 3 are disposed on these conductive adhesive films 20.

Moreover, by carrying out a heating and pressing process onto the tab wires 3 at a predetermined pressure, the tab wires 3, the bus bar electrodes 11 and the A1 back-surface electrode 13 are electrically connected to one another. At this time, the tab wires 3 are firmly connected to the bus bar electrodes 11 mechanically, because the binder resin of the conductive adhesive films 20 has a superior adhesion property with the bus bar electrodes 11 formed by using the Ag paste. Moreover, the tab wires 3 are electrically connected to the A1 back-surface electrode 13.

The matrix 5 to which the solar cell 2 is connected is sandwiched by sheets 6 of a sealing adhesive agent, and laminated together with the surface cover 7 formed on the light-receiving surface side as a protective material and the back sheet 8 formed on the back-surface side in a batch process so that a solar cell module 1 is produced.

In accordance with this production method for a solar cell module, since the aforementioned conductive adhesive film contains an acrylic resin, a radical polymerization initiator and conductive particles, with its glass transition temperature after the curing process being set to 150°C or more to 180°C or less and its tan δ peak value being set to 0.25 or more to 0.60 or less, the tab wires and the electrodes can be firmly joined to each other by a heating and pressing process at a comparatively low temperature of 200°C or less at the time of the pressing operation by a heating and pressing head so that high connection reliability can be obtained.

Moreover, not limited by the above-mentioned production method for the solar cell module, another method may be used in which a surface electrode of one solar cell and a tab wire, as well as a back-surface electrode of another solar cell and a tab wire, are temporarily secured, with the aforementioned adhesive conductive film being interposed therebetween, and by successively stacking a sealing material and a protective substrate on each of the upper and lower surfaces of the solar cell, a laminate press-bonding process is carried out onto the upper surface of the protective substrate by a laminate device (reduced-pressure laminator) so that the sealing material is cured, with the surface electrode and the tab wires, as well as the back-surface electrode and the tab wires, being connected to each other.

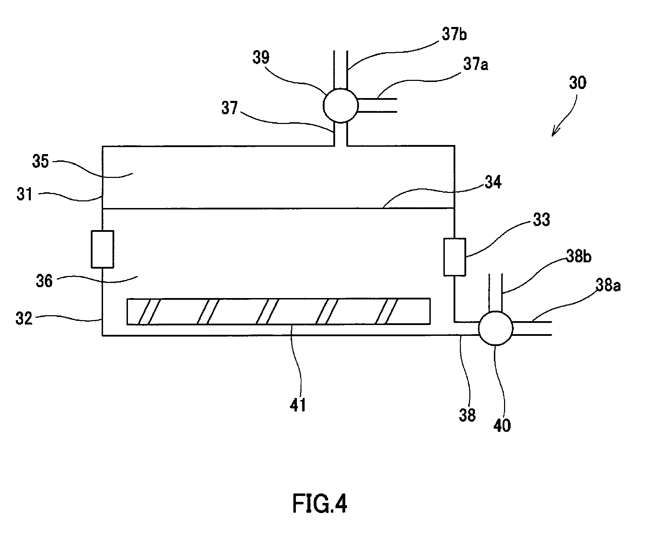

Fig. 4 is a drawing that shows a structure of the reduced-pressure laminator. The reduced pressure laminator 30 is constituted by an upper unit 31 and a lower unit 32. These units are integrally formed into one unit, with a sealing member 33 such as an O-ring being interposed therebetween, in such a manner as to be separated. A flexible sheet 34 made of silicone rubber or the like is formed on the upper unit 31, and by this flexible sheet 34, a first chamber 35 and a second chamber 36 of the reduced-pressure laminator 30 are separated from each other.

Pipes 37 and 38 are respectively formed in the upper unit 31 and the lower unit 32 so as to independently adjust the inner pressures of the respective chambers, that is, so as to reduce the pressure, increase the pressure and further release it to the atmospheric pressure by using a vacuum pump, a compressor, or the like. The pipe 37 is branched into two directions, that is, to a pipe 37a and a pipe 37b, by a switching valve 39, and the pipe 38 is branched into two directions, that is, a pipe 38a and a pipe 38b, by a switching valve 40. Moreover, a stage 41 that can be heated is installed on the lower unit 32.

Next, the following description will discuss a specific connection method by the use of this reduced-pressure laminator 30. First, the upper unit 31 and the lower unit 32 are separated from each other, and on the stage 41, a laminated member formed by successively stacking a sealing material and protective substrates (surface cover 7 and back sheet 8) is mounted on each of the upper and lower surfaces of the solar cell on which the tab wires are temporarily secured.

Moreover, the upper unit 31 and the lower unit 32 are integrally formed into one unit with the sealing material 33 interposed therebetween in a manner so as to be separated from each other, and vacuum pumps are then respectively connected to the pipe 37a and the pipe 38a so that the first chamber 35 and the second chamber 36 are brought to a highly vacuumed state. With the inside of the second chamber 36 being kept at the highly vacuumed state, the switching valve 39 is switched so that the atmospheric air is introduced into the first chamber 35 from the pipe 37b. Thus, the flexible sheet 34 is pushed and widened toward the second chamber 36, with the result that the laminated member is pressed by the flexible sheet 34, while being heated by the stage 41.

After the thermal press-bonding process, the switching valve 40 is switched so that the atmospheric air is introduced into the second chamber 36 from the pipe 38b. Thus, the flexible sheet 34 is pressed back toward the first chamber 35 so that the inner pressures of the first chamber 35 and the second chamber 36 become the same pressure finally.

Lastly, the upper unit 31 and the lower unit 32 are separated from each other, and a solar cell module that has been subjected to the thermal press-bonding process is taken out from the stage 41. Thus, the curing process of the sealing resin and the connection between the electrode and the tab wire can be carried out simultaneously.

In accordance with this production method for a solar cell module, since the aforementioned conductive adhesive film contains an acrylic resin, a radical polymerization initiator and conductive particles, with its glass transition temperature after the curing process being set to 150°C or more to 180°C or less and its tan δ peak value being set to 0.25 or more to 0.60 or less, the tab wires and the electrodes can be firmly joined to each other by the thermal press-bonding process at a comparatively low temperature of 200°C or less at the time of the thermal press-bonding process so that high connection reliability can be obtained.

### EXAMPLES

### <5. Examples>

The following description will discuss examples of the present invention; however, the present invention is not intended to be limited by these examples.

In this case, first, film-forming resin composites having respectively different compositions were prepared, and a glass transition temperature and a tan δ peak value of each of cured products were measured. Moreover, by using each of the film-forming resin composites, acryl-based thermosetting-type conductive adhesive films were formed, and by using each of the conductive adhesive films, a solar cell module was formed, and its power generation efficiency was evaluated.

Moreover, the hardness of each of the film-forming resin composites was measured. Furthermore, by using each of the film-forming resin composites, an adhesive agent reel was produced, and the amount of generation of oozing was evaluated.

The measurements of the glass transition temperature and the tan δ peak value, the evaluation of the power generating efficiency, the measurement of the hardness and the evaluation of oozing were carried out in the following manner.

### <Measurements of Glass Transition Temperature and Tan δ Peak Value>

Each of the film-forming resin composite was cut into a predetermined size, and cured under conditions at 160°C for 10 minutes to prepare a measuring sample.

The measuring sample was measured for its elastic modulus under conditions of a chuck-to-chuck distance of 5 cm, a measured frequency of 11 Hz and a temperature-raising rate of 3°C/min, by using a DMA (dynamic analyzer) visco-elasticity measuring device (trade name: Rheovibron DDV-01FP, made by Orientec Co., Ltd.). Supposing that the peak temperature of tan δ at the time of the measuring process of the elastic modulus as a glass transition temperature (Tg), the tan δ peak value was found.

### <Evaluation of Power Generating Efficiency>

The film-forming resin composite was applied onto a substrate film subjected to a peeling treatment by using a bar coater, and dried in an oven at 80°C for 5 minutes so that an acryl-based thermosetting-type conductive adhesive film with a thickness of 25 µm was produced.

Next, the conductive adhesive film was pasted onto each of a surface electrode portion made of Ag and a back-surface electrode portion made of A1 of a 6-inch polycrystal Si cell (dimension: 15.6 cm × 15.6 cm, thickness: 180 µm), and a Cu tab wire (width: 2 mm, thickness: 0.15 mm) coated with solder was thermally pressed (160°C, 5 seconds, 1 MPa) onto the conductive adhesive film by a heater head so as to be secured thereon.

This solar cell module to which the tab wire had been secured was sandwiched by sheets of a sealing adhesive agent, and was laminated together with a surface cover formed on a light-receiving surface side and a back sheet formed on a back-surface side in a batch process.

The photoelectric conversion efficiency of the solar cell module was measured in accordance with JIS C8913 (crystal-based solar cell output measuring method) by using a solar simulator (PVS1116i, made by Nisshinbo Mechatronics Inc.).

In the case when, supposing that the initial power generating efficiency in the solar cell module is 100%, the power generating efficiency after a thermal shock test (TCT: - 40°C, 3 hours ← → 110°C, 3 hours, 1000 cycles) was 97% or more, this state was evaluated as ○, when it was 95% or more to 97% or less, this state was evaluated as Δ, and when it was less than 95%, this state was evaluated as ×.

### <Measurements of Hardness>

The film-forming resin composite prepared as described above was set in a type C durometer (Asker rubber hardness meter C2 type, made by Kobunshi Keiki Co., Ltd.), and the hardness was measured 300 seconds after the contact of the indenter point at room temperature.

### <Evaluation of Oozing>

The film-forming resin composite prepared as described above was applied onto a substrate film subjected to a peeling treatment by using a bar coater, and dried in an oven at 80°C for 5 minutes so that an acryl-based thermosetting-type conductive adhesive film with a thickness of 25 µm was produced. While the conductive adhesive film was being cut with a width of 1.0 mm by a slitting blade vertically pressed onto a surface on the side opposite to the substrate film side of the conductive adhesive film, a tape made of the conductive adhesive film was wound into a reel of 300 m at a velocity of 0.1 m/s so that an adhesive agent reel was formed.

Moreover, with the adhesive agent reel being secured so as not to rotate, while a load of 50 gf was being applied to the tip of the tape drawn from the adhesive agent reel, the tape was held in a thermostat at 30°C for two hours. When the amount of oozing (protrusion) from the rolling core of the reel was less than 2 layers, this state was evaluated as ○, when it was less than 3 layers, this state was evaluated as Δ, and when it was 3 layers or more, this state was evaluated as ×. Additionally, these determinations were made by visual observations through a microscope.

### [Example 1]

A phenoxy resin (trade name: FX280, made by Nippon Steel Chemical Co., Ltd.) (20 parts by mass) was used as a film-forming resin. As thermoplastic elastomers, acrylic rubber (trade name: SG Series, made by Nagase ChemteX Corporation) (3 parts by mass) and SEBS (styrene-ethylene-butylene-styrene) (trade name: Tough-tek Series, made by Asahi Kasei Chemicals Corporation) (12 parts by mass) were used. As acrylates, epoxy acrylate (trade name: V#540, made by Osaka Organic Chemical Industry Ltd.) (22 parts by mass), dimethacrylate (trade name: NK Ester DCP, made by Shin-Nakamura Chemical Co., Ltd.) (37 parts by mass) and acrylate containing a phosphoric acid ester group (trade name: PM Series, made by Nippon Kayaku Co., Ltd.) (2 parts by mass) were used. As a silane coupling agent, methacryloxy silane (trade name: KBE503, made by Shin-Etsu Chemical Co., Ltd.) (1 part by mass) was used. As an inorganic filler, silica (trade name: Aerosil Series, made by Nippon Aerosil Co., Ltd.) (5 parts by mass) was used. As a polymerization initiator, an organic peroxide (trade name: Nyper BMT, made by NOF Corporation) (5 parts by mass) was used. As conductive particles, Ni powder (5 parts by mass) was used. By compounding these film-forming resin, thermoplastic elastomer, acrylate, silane coupling agent, inorganic filler, polymerization initiator and conductive particles, a film-forming resin composite was prepared.

As a result of measurements on the elastic modulus of the film-forming resin composite of example 1, the glass transition temperature (Tg) was 150°C and the tan δ peak value was 0.46. Moreover, the evaluation result of the power generating efficiency of a solar cell module produced by using the film-forming resin composite of example 1 was Δ. The Asker C2 hardness of the film-forming resin composite of example 1 was 52. Furthermore, with respect to an adhesive agent reel produced by using the film-forming resin composite of example 1, the evaluation result of oozing thereof was ○. Table 1 shows the results of these measurements.

### [Example 2]

As acrylates, dimethacrylate (trade name: NK Ester DCP, made by Shin-Nakamura Chemical Co., Ltd.) (37 parts by mass), triacrylate (trade name: NK Ester A9300, made by Shin-Nakamura Chemical Co., Ltd.) (22 parts by mass) and acrylate containing a phosphoric acid ester group (trade name: PM Series, made by Nippon Kayaku Co., Ltd.) (2 parts by mass) were used. Except for these points, the same processes as those of example 1 were carried out so that a film-forming resin composite was prepared.

As a result of measurements on the elastic modulus of the film-forming resin composite of example 2, the glass transition temperature (Tg) was 168°C and the tan δ peak value was 0.27. Moreover, the evaluation result of the power generating efficiency of a solar cell module produced by using the film-forming resin composite of example 2 was Δ. The Asker C2 hardness of the film-forming resin composite of example 2 was 50. Furthermore, with respect to an adhesive agent reel produced by using the film-forming resin composite of example 2, the evaluation result of oozing thereof was ○. Table 1 shows the results of these measurements.

### [Example 3]

As thermoplastic elastomers, acrylic rubber (trade name: SG Series, made by Nagase ChemteX Corporation) (5 parts by mass) and SEBS (trade name: Tough-tek Series, made by Asahi Kasei Chemicals Corporation) (15 parts by mass) were used.
As acrylates, epoxy acrylate (trade name: V#540, made by Osaka Organic Chemical Industry Ltd.) (5 parts by mass), dimethacrylate (trade name: NK Ester DCP, made by Shin-Nakamura Chemical Co., Ltd.) (24 parts by mass), caprolactone-modified triacrylate (trade name: NK Ester A9300-1CL, made by Shin-Nakamura Chemical Co., Ltd.) (15 parts by mass), triacrylate (trade name: NK Ester A9300, made by Shin-Nakamura Chemical Co., Ltd.) (10 parts by mass) and acrylate containing a phosphoric acid ester group (trade name: PM Series, made by Nippon Kayaku Co., Ltd.) (2 parts by mass) were used. Except for these points, the same processes as those of example 1 were carried out so that a film-forming resin composite was prepared.

As a result of measurements on the elastic modulus of the film-forming resin composite of example 3, the glass transition temperature (Tg) was 165°C and the tan δ peak value was 0.60. Moreover, the evaluation result of the power generating efficiency of a solar cell module produced by using the film-forming resin composite of example 3 was Δ. The Asker C2 hardness of the film-forming resin composite of example 3 was 53. Furthermore, with respect to an adhesive agent reel produced by using the film-forming resin composite of example 3, the evaluation result of oozing thereof was ○. Table 1 shows the results of these measurements.

### [Example 4]

As thermoplastic elastomers, acrylic rubber (trade name: SG Series, made by Nagase ChemteX Corporation) (5 parts by mass) and SEBS (trade name: Tough-tek Series, made by Asahi Kasei Chemicals Corporation) (15 parts by mass) were used.
As acrylates, epoxy acrylate (trade name: V#540, made by Osaka Organic Chemical Industry Ltd.) (5 parts by mass), dimethacrylate (trade name: NK Ester DCP, made by Shin-Nakamura Chemical Co., Ltd.) (24 parts by mass), triacrylate (trade name: NK Ester A9300, made by Shin-Nakamura Chemical Co., Ltd.) (25 parts by mass) and acrylate containing a phosphoric acid ester group (trade name: PM Series, made by Nippon Kayaku Co., Ltd.) (2 parts by mass) were used. As an inorganic filler, silica (trade name: Aerosil Series, made by Nippon Aerosil Co., Ltd.) (1 part by mass) was used. Except for these points, the same processes as those of example 1 were carried out so that a film-forming resin composite was prepared.

As a result of measurements on the elastic modulus of the film-forming resin composite of example 4, the glass transition temperature (Tg) was 172°C and the tan δ peak value was 0.50. Moreover, the evaluation result of the power generating efficiency of a solar cell module produced by using the film-forming resin composite of example 4 was ○. The Asker C2 hardness of the film-forming resin composite of example 4 was 48. Furthermore, with respect to an adhesive agent reel produced by using the film-forming resin composite of example 4, the evaluation result of oozing thereof was Δ. Table 1 shows the results of these measurements.

### [Example 5]

As thermoplastic elastomers, acrylic rubber (trade name: SG Series, made by Nagase ChemteX Corporation) (5 parts by mass) and SEBS (trade name: Tough-tek Series, made by Asahi Kasei Chemicals Corporation) (15 parts by mass) were used.
As acrylates, epoxy acrylate (trade name: V#540, made by Osaka Organic Chemical Industry Ltd.) (5 parts by mass), dimethacrylate (trade name: NK Ester DCP, made by Shin-Nakamura Chemical Co., Ltd.) (24 parts by mass), triacrylate (trade name: NK Ester A9300, made by Shin-Nakamura Chemical Co., Ltd.) (25 parts by mass) and acrylate containing a phosphoric acid ester group (trade name: PM Series, made by Nippon Kayaku Co., Ltd.) (2 parts by mass) were used. As an inorganic filler, silica (trade name: Aerosil Series, made by Nippon Aerosil Co., Ltd.) (3 parts by mass) was used. Except for these points, the same processes as those of example 1 were carried out so that a film-forming resin composite was prepared.

As a result of measurements on the elastic modulus of the film-forming resin composite of example 5, the glass transition temperature (Tg) was 172°C and the tan δ peak value was 0.51. Moreover, the evaluation result of the power generating efficiency of a solar cell module produced by using the film-forming resin composite of example 5 was ○. The Asker C2 hardness of the film-forming resin composite of example 5 was 53. Furthermore, with respect to an adhesive agent reel produced by using the film-forming resin composite of example 5, the evaluation result of oozing thereof was ○. Table 1 shows the results of these measurements.

### [Example 6]

As thermoplastic elastomers, acrylic rubber (trade name: SG Series, made by Nagase ChemteX Corporation) (5 parts by mass) and SEBS (trade name: Tough-tek Series, made by Asahi Kasei Chemicals Corporation) (15 parts by mass) were used.
As acrylates, epoxy acrylate (trade name: V#540, made by Osaka Organic Chemical Industry Ltd.) (5 parts by mass), dimethacrylate (trade name: NK Ester DCP, made by Shin-Nakamura Chemical Co., Ltd.) (24 parts by mass), triacrylate (trade name: NK Ester A9300, made by Shin-Nakamura Chemical Co., Ltd.) (25 parts by mass) and acrylate containing a phosphoric acid ester group (trade name: PM Series, made by Nippon Kayaku Co., Ltd.) (2 parts by mass) were used. As an inorganic filler, silica (trade name: Aerosil Series, made by Nippon Aerosil Co., Ltd.) (9 parts by mass) was used. Except for these points, the same processes as those of example 1 were carried out so that a film-forming resin composite was prepared.

As a result of measurements on the elastic modulus of the film-forming resin composite of example 6, the glass transition temperature (Tg) was 172°C and the tan δ peak value was 0.51. Moreover, the evaluation result of the power generating efficiency of a solar cell module produced by using the film-forming resin composite of example 6 was Δ. The Asker C2 hardness of the film-forming resin composite of example 6 was 76. Furthermore, with respect to an adhesive agent reel produced by using the film-forming resin composite of example 6, the evaluation result of oozing thereof was ○. Table 1 shows the results of these measurements.

### [Comparative Example 1]

As acrylates, epoxy acrylate (trade name: V#540, made by Osaka Organic Chemical Industry Ltd.) (27 parts by mass), dimethacrylate (trade name: NK Ester DCP, made by Shin-Nakamura Chemical Co., Ltd.) (32 parts by mass) and acrylate containing a phosphoric acid ester group (trade name: PM Series, made by Nippon Kayaku Co., Ltd.) (2 parts by mass) were used. No inorganic filler was used. Except for these points, the same processes as those of example 1 were carried out so that a film-forming resin composite was prepared.

As a result of measurements on the elastic modulus of the film-forming resin composite of comparative example 1, the glass transition temperature (Tg) was 147°C and the tan δ peak value was 0.46. Moreover, the evaluation result of the power generating efficiency of a solar cell module produced by using the film-forming resin composite of comparative example 1 was ×. The Asker C2 hardness of the film-forming resin composite of comparative example 1 was 42. Furthermore, with respect to an adhesive agent reel produced by using the film-forming resin composite of comparative example 1, the evaluation result of oozing thereof was ×. Table 2 shows the results of these measurements.

### [Comparative Example 2]

As acrylates, epoxy acrylate (trade name: V#540, made by Osaka Organic Chemical Industry Ltd.) (15 parts by mass), dimethacrylate (trade name: NK Ester DCP, made by Shin-Nakamura Chemical Co., Ltd.) (22 parts by mass), triacrylate (trade name: NK Ester A9300, made by Shin-Nakamura Chemical Co., Ltd.) (22 parts by mass) and acrylate containing a phosphoric acid ester group (trade name: PM Series, made by Nippon Kayaku Co., Ltd.) (2 parts by mass) were used. No inorganic filler was used. Except for these points, the same processes as those of example 1 were carried out so that a film-forming resin composite was prepared.

As a result of measurements on the elastic modulus of the film-forming resin composite of comparative example 2, the glass transition temperature (Tg) was 170°C and the tan δ peak value was 0.24. Moreover, the evaluation result of the power generating efficiency of a solar cell module produced by using the film-forming resin composite of comparative example 2 was ×. The Asker C2 hardness of the film-forming resin composite of comparative example 2 was 43. Furthermore, with respect to an adhesive agent reel produced by using the film-forming resin composite of comparative example 2, the evaluation result of oozing thereof was ×. Table 2 shows the results of these measurements.

### [Comparative Example 3]

As thermoplastic elastomers, acrylic rubber (trade name: SG Series, made by Nagase ChemteX Corporation) (5 parts by mass) and SEBS (trade name: Tough-tek Series, made by Asahi Kasei Chemicals Corporation) (15 parts by mass) were used.
As acrylates, epoxy acrylate (trade name: V#540, made by Osaka Organic Chemical Industry Ltd.) (5 parts by mass), dimethacrylate (trade name: NK Ester DCP, made by Shin-Nakamura Chemical Co., Ltd.) (24 parts by mass), caprolactone-modified triacrylate (trade name: NK Ester A9300-1CL, made by Shin-Nakamura Chemical Co., Ltd.) (25 parts by mass) and acrylate containing a phosphoric acid ester group (trade name: PM Series, made by Nippon Kayaku Co., Ltd.) (2 parts by mass) were used. No inorganic filler was used. Except for these points, the same processes as those of example 1 were carried out so that a film-forming resin composite was prepared.

As a result of measurements on the elastic modulus of the film-forming resin composite of comparative example 3, the glass transition temperature (Tg) was 161°C and the tan δ peak value was 0.66. Moreover, the evaluation result of the power generating efficiency of a solar cell module produced by using the film-forming resin composite of comparative example 3 was ×. The Asker C2 hardness of the film-forming resin composite of comparative example 3 was 44. Furthermore, with respect to an adhesive agent reel produced by using the film-forming resin composite of comparative example 3, the evaluation result of oozing thereof was ×. Table 2 shows the results of these measurements.

### [Comparative Example 4]

As thermoplastic elastomers, acrylic rubber (trade name: SG Series, made by Nagase ChemteX Corporation) (5 parts by mass) and SEBS (trade name: Tough-tek Series, made by Asahi Kasei Chemicals Corporation) (15 parts by mass) were used.
As acrylates, dimethacrylate (trade name: NK Ester DCP, made by Shin-Nakamura Chemical Co., Ltd.) (24 parts by mass), triacrylate (trade name: NK Ester A9300, made by Shin-Nakamura Chemical Co., Ltd.) (30 parts by mass) and acrylate containing a phosphoric acid ester group (trade name: PM Series, made by Nippon Kayaku Co., Ltd.) (2 parts by mass) were used. No inorganic filler was used. Except for these points, the same processes as those of example 1 were carried out so that a film-forming resin composite was prepared.

As a result of measurements on the elastic modulus of the film-forming resin composite of comparative example 4, the glass transition temperature (Tg) was 182°C and the tan δ peak value was 0.43. Moreover, the evaluation result of the power generating efficiency of a solar cell module produced by using the film-forming resin composite of comparative example 4 was ×. The Asker C2 hardness of the film-forming resin composite of comparative example 4 was 42. Furthermore, with respect to an adhesive agent reel produced by using the film-forming resin composite of comparative example 4, the evaluation result of oozing thereof was ×. Table 2 shows the results of these measurements.

### [Comparative Example 5]

As thermoplastic elastomers, acrylic rubber (trade name: SG Series, made by Nagase ChemteX Corporation) (5 parts by mass) and SEBS (trade name: Tough-tek Series, made by Asahi Kasei Chemicals Corporation) (15 parts by mass) were used.
As acrylates, epoxy acrylate (trade name: V#540, made by Osaka Organic Chemical Industry Ltd.) (5 parts by mass), dimethacrylate (trade name: NK Ester DCP, made by Shin-Nakamura Chemical Co., Ltd.) (24 parts by mass), triacrylate (trade name: NK Ester A9300, made by Shin-Nakamura Chemical Co., Ltd.) (25 parts by mass) and acrylate containing a phosphoric acid ester group (trade name: PM Series, made by Nippon Kayaku Co., Ltd.) (2 parts by mass) were used. As an inorganic filler, silica (trade name: Aerosil Series, made by Nippon Aerosil Co., Ltd.) (11 parts by mass) was used. Except for these points, the same processes as those of example 1 were carried out so that a film-forming resin composite was prepared.

As a result of measurements on the elastic modulus of the film-forming resin composite of comparative example 5, the glass transition temperature (Tg) was 172°C and the tan δ peak value was 0.52. Moreover, with respect to a solar cell module produced by using the film-forming resin composite of comparative example 5, since the film was too hard, it was not possible to push the conductive particles therein, making it difficult to secure conduction. The Asker C2 hardness of the film-forming resin composite of comparative example 5 was 81. Furthermore, with respect to an adhesive agent reel produced by using the film-forming resin composite of comparative example 5, the evaluation result of oozing thereof was ○. Table 2 shows the results of these measurements.

**[Table 1]**

| Raw material | | Example 1 | Example 2 | Example 3 | Example 4 | Example 5 | Example 6 |
|---|---|---|---|---|---|---|---|
| Film-forming resin | Phenoxy resin | 20 | 20 | 20 | 20 | 20 | 20 |
| Thermoplastic elastomer | Acrylic rubber | 3 | 3 | 5 | 5 | 5 | 5 |
| | SEBS | 12 | 12 | 15 | 15 | 15 | 15 |
| Acrylate | Epoxy acrylate | 22 | 0 | 5 | 5 | 5 | 5 |
| | Dimethacrylate | 37 | 37 | 24 | 24 | 24 | 24 |
| | Caprolactone-modified triacrylate | 0 | 0 | 15 | 0 | 0 | 0 |
| | Triacrylate | 0 | 22 | 10 | 25 | 25 | 25 |
| | Acrylate containing a phosphoric acid ester group | 2 | 2 | 2 | 2 | 2 | 2 |
| Silane coupling agent | Methacrylosilane | 1 | 1 | 1 | 1 | 1 | 1 |
| Inorganic filler | Silica | 3 | 3 | 3 | 1 | 3 | 9 |
| Radical polymerization initiator | Organic peroxide | 5 | 5 | 5 | 5 | 5 | 5 |
| Conductive particles | Ni powder | 15 | 15 | 15 | 15 | 15 | 15 |
| Glass transition temperature (°C) | | 150 | 168 | 165 | 172 | 172 | 172 |
| tan δ peak value | | 0.46 | 0.27 | 0.60 | 0.50 | 0.51 | 0.51 |
| Evaluation of power generating efficiency | | Δ | Δ | Δ | ○ | ○ | Δ |
| Asker C2 hardness | | 52 | 50 | 53 | 48 | 53 | 76 |
| Evaluation of oozing | | ○ | ○ | ○ | Δ | ○ | ○ |

**[Table 2]**

| Raw material | | Comparative Example 1 | Comparative Example 2 | Comparative Example 3 | Comparative Example 4 | Comparative Example 5 |
|---|---|---|---|---|---|---|
| Film-forming resin | Phenoxy resin | 20 | 20 | 20 | 20 | 20 |
| Thermoplastic elastomer | Acrylic rubber | 3 | 3 | 5 | 5 | 5 |
| | SEBS | 12 | 12 | 15 | 15 | 15 |
| Acrylate | Epoxy acrylate | 27 | 15 | 5 | 0 | 5 |
| | Dimethacrylate | 32 | 22 | 24 | 24 | 24 |
| | Caprolactone-modified triacrylate | 0 | 0 | 25 | 0 | 0 |
| | Triacrylate | 0 | 22 | 0 | 30 | 25 |
| | Acrylate containing a phosphoric acid ester group | 2 | 2 | 2 | 2 | 2 |
| Silane coupling agent | Methacrylosilane | 1 | 1 | 1 | 1 | 1 |
| Inorganic filler | Silica | 0 | 0 | 0 | 0 | 11 |
| Radical polymerization initiator | Organic peroxide | 5 | 5 | 5 | 5 | 5 |
| Conductive particles | Ni powder | 15 | 15 | 15 | 15 | 15 |
| Glass transition temperature (°C) | | 147 | 170 | 161 | 182 | 172 |
| tan 5 peak value | | 0.46 | 0.24 | 0.66 | 0.43 | 0.52 |
| Evaluation of power generating efficiency | | × | × | × | × | ×_{*1} |
| Asker C2 hardness | | 42 | 43 | 44 | 42 | 81 |
| Evaluation of oozing | | × | × | × | × | ○ |

| | | | | | | |
|---|---|---|---|---|---|---|
| * 1...No conduction secured | | | | | | |

As shown in examples 1 to 6, by setting the glass transition temperature after a curing process of the film-forming resin composite to 150°C or more to 180°C or less, with the tan δ peak value being set to 0.25 or more to 0.60 or less, it becomes possible to provide superior heat resistance. Therefore, by using a conductive adhesive film composed of the film-forming resin composite for connection between an electrode and a tab wire of a solar cell, it becomes possible to provide superior power generating efficiency in a solar cell module.

In the case when, as shown in comparative example 1, the glass transition temperature after a curing process of a film-forming resin composite was less than 150°C, as well as when, as shown in comparative example 4, the glass transition temperature after the curing process thereof exceeded 180°C, the power generating efficiency after a heat shock test was drastically lowered. Moreover, in the case when, as shown in comparative example 2, the tan δ peak value after a curing process of the film-forming resin composite was less than 0.25, as well as when, as shown in comparative example 3, the tan δ peak value after the curing process thereof exceeded 0.60, the power generating efficiency after a heat shock test was drastically lowered.

As shown in examples 1 to 6, by setting the Asker C2 hardness of the film-forming resin composite prior to a curing process (uncured) to 45 or more to 80 or less, it was possible to suppress an occurrence of oozing. In contrast, as shown in comparative examples 1 to 4, in the case when the Asker C2 hardness of the film-forming resin composite prior to the curing process (uncured) was less than 45, the occurrence of oozing was found in many layers. Moreover, as shown in comparative example 5, in the case when the Asker C2 hardness of the film-forming resin composite prior to the curing process (uncured) exceeded 80, it became difficult to sufficiently push conductive particles therein at the time of the thermal press-bonding process, failing to secure conduction in the initial stage.

### Reference Signs List

1 ... solar cell module, 2...solar cell, 3...tab wire, 4...strings, 5...matrix, 6...sheet, 7...surface cover, 8...back sheet, 9...metal frame, 10...photoelectric conversion element, 11...busbar electrode, 12...finger electrode, 13...A1 back-surface electrode, 20...conductive adhesive film, 21...peeling substrate, 22...reel, 30...reduced-pressure laminator, 31...upper unit, 32...lower unit, 33...sealing member, 34...flexible sheet, 35...first chamber, 36...second chamber, 37, 38...pipe, 39, 40...switching valve, 41...stage

## Claims

1. A conductive adhesive comprising:
an acrylic resin, a radical polymerization initiator and conductive particles, wherein the conductive adhesive has a glass transition temperature after a curing process in a range from 150°C or more to 180°C or less, with a tan δ peak value being set to 0.25 or more to 0.60 or less.

2. The conductive adhesive according to claim 1, wherein an Asker C2 hardness before a curing process is set in a range from 45 or more to 80 or less.

3. The conductive adhesive according to claim 1 or 2, further comprising:
an inorganic filler.

4. The conductive adhesive according to any one of claims 1 to 3, wherein the acrylic resin contains an acrylate containing a phosphoric acid ester group and the radical polymerization initiator is an organic peroxide.

5. A solar cell module comprising:
one solar cell and the other solar cell adjacent to the one solar cell, each solar cell having a surface electrode and a back-surface electrode, with the surface electrode of the one solar cell and the back-surface electrode of the other solar cell being electrically connected to a tab wire, with a conductive adhesive being interposed therebetween,
wherein the conductive adhesive contains an acrylic resin, a radical polymerization initiator and conductive particles, with the conductive adhesive having a glass transition temperature after a curing process in a range from 150°C or more to 180°C or less, and with a tan δ peak value being set to 0.25 or more to 0.60 or less.

6. A method for manufacturing a solar cell module comprising the steps of:
preparing one solar cell and the other solar cell adjacent to the one solar cell, each solar cell having a surface electrode and a back-surface electrode, with the surface electrode of the one solar cell and the back-surface electrode of the other solar cell being electrically connected by a tab wire, with a conductive adhesive being interposed therebetween,
wherein the tab wire is disposed on the surface electrode and the back surface substrate with a conductive adhesive, which contains an acrylic resin, a radical polymerization initiator and conductive particles, and has a glass transition temperature after a curing process in a range from 150°C or more to 180°C or less, with a tan δ peak value being set to 0.25 or more to 0.60 or less, being interposed therebetween, and thermally pressed thereon.
